# EUROPEAN PATENT APPLICATION

(11) **EP 4 198 169 A1**
(43) Date of publication of application: **21.06.2023**
(21) Application number: 21214228.5
(22) Date of filing: 14.12.2021
(51) Int. Cl.: C23C 28/04, C23C 14/06, C23C 28/00, C23C 30/00, C23C 14/32

(54) **CUTTING TOOL**

(71) Applicant: CERATIZIT Austria Gesellschaft m.b.H., 6600 Reutte (AT); CERATIZIT Balzheim GmbH & Co. KG, 88481 Balzheim (DE)
(72) Inventor: POHLER, Markus, 6600 Reutte (AT); CZETTL, Christoph, 6600 Reutte (AT); SHAHA, Kalpak Prakash, 88481 Balzheim (DE)
(74) Representative: Ciesla, Dirk

(57) **Abstract**

Cutting tool (1, 10), the cutting tool (1, 10) has a tool body (2) and a multilayer coating (3, 30), wherein the multilayer coating (3, 30) protects the tool body (2) against wear during cutting, wherein the multilayer coating (3, 30) has zirconium nitride layers (4), wherein the multilayer coating (3, 30) has further nitride layers (5) alternatingly stacked with the zirconium nitride layers (4), such that each of the further nitride layers (5) carries one of the zirconium nitride layers (4), wherein the further nitride layers (5) each have an atomic composition of (Ti_{1-x-y}AlₓMe_{y})Nₐ, wherein at least one of the zirconium nitride layers (4) is thicker than one of the further nitride layers (5) which carries said thicker zirconium nitride layer (4).

## Description

The present invention relates to a cutting tool, the cutting tool has a tool body and a multilayer coating, wherein the multilayer coating protects the tool body against wear during cutting, wherein the multilayer coating has zirconium nitride layers, wherein the multilayer coating has further nitride layers alternatingly stacked with the zirconium nitride layers, such that each of the further nitride layers carries one of the zirconium nitride layers, wherein the further nitride layers each have an atomic composition of (Ti_{1-x-y}AlₓMe_{y})N_{α}, wherein x = 0.20 to 0.90 and y = 0 to 0.30, wherein Me is one or more metal atoms each selected from Ta, Si, Cr, W, V, Cr, Hf, Nb and Mo, wherein α = 0.9 to 1.1, wherein each of the zirconium nitride layers has a thickness in the range from 35 nm to 750 nm.

Cutting tools experience high loads and frictional contact with workpieces and machined chips, leading to wear. It is known to improve tool life by applying a suitable coating to said cutting tools.

WO 2009/105024 A1 shows a multi-layered coated cutting tool. The coating shown in

WO 2009/105024 A1 comprises a polycrystalline laminar, multi-layered structure of metal nitride compounds, in a repetitive form of MeN/(Ti₁₋ₓAlₓ)N/MeN/(Ti₁₋ₓAlₓ)N/ ...., where Me can be Zr amongst other possible metal atoms.

The multilayer coatings shown in WO 2009/105024 A1 are subject to wear themselves, especially when chips are pressure-welded onto said coatings under high thermal and mechanical loads. When the multilayer coatings of WO 2009/105024 A1 are worn down, their protective effect naturally vanishes, which reduces tool life.

It is an object of the present invention to provide a cutting tool having an improved wear resistance.

The objective is solved by the cutting tool according to claim 1. Advantageous embodiments of this cutting tool are disclosed in the dependent claims, which can be freely combined amongst each other and with claim 1, the description and the figures.

The cutting tool has a tool body and a multilayer coating, wherein the multilayer coating protects the tool body against wear during cutting, wherein the multilayer coating has zirconium nitride layers, wherein the multilayer coating has further nitride layers alternatingly stacked with the zirconium nitride layers, such that each of the further nitride layers carries one of the zirconium nitride layers, wherein the further nitride layers each have an atomic composition of (Ti_{1-x-y}AlₓMe_{y})N_{α}, wherein x = 0.20 to 0.90 and y = 0 to 0.30, preferably from x = 0.40 to 0.80 and y = 0 to 0.30, wherein Me is one or more metal atoms each selected from Ta, Si, Cr, W, V, Cr, Hf, Nb and Mo, wherein α = 0.9 to 1.1, wherein each of the zirconium nitride layers has a thickness in the range from 35 nm to 750 nm, wherein each of the further nitride layers has a thickness in the range from 30 nm to 300 nm, wherein at least one of the zirconium nitride layers is thicker than one of the further nitride layers which carries said thicker zirconium nitride layer.

The zirconium nitride layers each improve resistance against adhesive wear which occurs when machined chips are pressure-welded onto the multilayer coating. The further nitride layer which carries said thicker zirconium nitride layer makes said thicker zirconium nitride layer harder which increases the resistance of said thicker zirconium nitride layer against adhesive wear as well as abrasive wear.

The atomic composition (Ti_{1-x-y}AlₓMe_{y})N_{α} has preferably one of the following combinations of (x, y and α): (x = 0.2 to 0.9, y = 0 to 0.3, α = 1.0), (x = 0.2 to 0.9, y = 0, α = 1.0), (x = 0.4 to 0.8, y = 0 to 0.3, α = 1.0), (x = 0.4 to 0.8, y = 0, α = 1.0).

The thickness of said thicker zirconium nitride layer is preferably in one of the following ranges: from 35 nm to 750 nm, from 200 nm to 600 nm, from 200 nm to 450 nm, from 200 nm to 350 nm.

The thickness of the further nitride layer which carries said thicker zirconium nitride layer is preferably in one of the following ranges: from 30 nm to 300 nm, from 50 nm to 150 nm, from 60 nm to 100 nm. Preferably each of the further nitride layers has a thickness in one of these ranges.

Preferably, at least two of the further nitride layers, even more preferred each further nitride layer, have the same atomic composition, such that that x, y and α are the same in each of the further nitride layers. The same atomic composition (same x, y and α) means that the values of x, y and α can vary from one further nitride layer to the other further nitride layer due to unavoidable fluctuations occurring during the formation of the further nitride layers, e.g., due to physical vapour deposition. In other words, x, y, and α can vary through the further nitride layers slightly even though they (x, y, and α) are intended to be (theoretically) the same.

According to a further embodiment of the cutting tool said thicker zirconium nitride layer is thicker than the further nitride layer which carries said thicker zirconium nitride layer by a factor in the range from 1.2 to 15.0, preferably from 2.0 to 12.0, more preferably from 3.0 to 10.0. The wear properties of said thicker zirconium nitride layers layer are even further improved when said thicker zirconium nitride layer is thicker than said further nitride layer by the factor in the range from 1.2 to 15.0, preferably from 2.0 to 12.0, more preferably from 3.0 to 10.0.

Said thicker zirconium nitride layer is preferably thicker than said further nitride layer by the factor in one of the following ranges: from 1.2 to 15.0, from 2.0 to 12.0, from 3.0 to 10.0, from 3.0 to 5.5, from 3.2 to 4.6.

According to a further embodiment of the cutting tool the cutting tool has a base layer, wherein the base layer has an atomic composition of (Ti_{1-a-b}AlₐMe^{∗}_{b})N_{β}, wherein a = 0.20 to 0.90 and b = 0 to 0.30, preferably a = 0.40 to 0.80 and b = 0 to 0.30, wherein β = 0.9 to 1.1, wherein Me^{∗} is one or more metal atoms each selected from Ta, Si, Cr, W, V, Cr, Hf, Nb and Mo, wherein the base layer carries the multilayer coating on parts of the tool body, wherein the base layer is thicker than any one of the further nitride layers. The presence of said multilayer coating on said base layer increases resistance against abrasive and adhesive wear and protects the tool body better against thermal loads. Preferably the base layer has the same atomic composition of one of the further nitride layers have, preferably the further nitride layer nearest to the base layer, meaning that Me^{∗} = Me, a=x, b = y, and α = β. The preferred ranges of x, y and α disclosed for the further nitrides layers apply to x, y, β analogously. Same atomic composition of the base layer and the further nitride layer means that a, b and β can vary with respect to said further nitride layer due to unavoidable fluctuations occurring during the formation of the further nitride layers, e.g., due to physical vapour deposition, even though the (theoretical) same atomic composition is intended.

According to a further embodiment of the cutting tool the base layer carries one of the zirconium nitride layers. Thereby, the base layer is better protected against adhesive wear, since the tool body carries a sequence of layers as follows: base layer / zirconium nitride layer / further nitride layer / zirconium nitride layer / ....

According to a further embodiment of the cutting tool the base layer has a total thickness in the range from 500 nm to 15000 nm, preferably from 1000 nm to 10000 nm. When the base layer has a total thickness in said ranges, the resistance against abrasive wear is further improved.

The total thickness of the base layer is preferably in one of the following ranges: from 500 nm to 15000 nm, from 1000 nm to 10000 nm, from 2000 nm to 4000 nm, from 2500 nm to 3700 nm.

According to a further embodiment of the cutting tool the base layer has a total thickness, wherein the multilayer coating has a total thickness, wherein a ratio of the total thickness of the base layer to the total thickness of the multilayer coating is in the range from larger than 0 to 3.0, preferably from 0.5 to 1.7. When the ratio of the total thickness of the base layer to the total thickness of the multilayer coating is in said ranges, tool life is further improved.

The ratio of the total thickness of the base layer to the total thickness of the multilayer coating is preferably in one of the following ranges: larger than 0 to 3.0, from 0.5 to 2.0, from 0.5 to 1.7, from 0.75 to 1.7.

According to a further embodiment of the cutting tool the tool body is made from a cemented carbide. The cemented carbide has a skeleton structure formed by carbide particles, wherein the cemented carbide has a metallic alloy which fills spaces formed by the skeleton structure, wherein the metallic alloy is softer than the carbide particles. Said cemented carbide is a material offering suitable properties to be used for the tool body under cutting conditions. The carbide particles can be tungsten carbide, titanium carbide and/or titanium carbonitride, whereby in smaller quantities additionally carbides of the elements of the groups IV to VI of the periodic table can be present. The metallic alloy is usually a cobalt base, nickel base or an iron base alloy. By a base alloy it is to be understood that that the corresponding base element, e.g., cobalt, forms the predominant component of the base alloy. The carbide particles are preferably tungsten carbide particles.

According to a further embodiment of the cutting tool, the cemented carbide has a metallic alloy which amounts from 5 weight percent to 20 weight percent in the cemented carbide, wherein the metallic alloy is a cobalt base alloy, wherein the cemented carbide has carbide particles which are tungsten carbide particles. Under these composition parameters a sufficient hardness and toughness on parts of the tool body is achieved to cut workpieces made from a metallic alloy, such as a titanium alloy or a steel alloy.

According to a further embodiment of the cutting tool the thickness of said thicker zirconium nitride layer and the thickness of the further nitride layer which carries said thicker zirconium nitride layer add up to a bilayer thickness in the range from 65 nm to 1050 nm, preferably from 125 nm to 750 nm. When the bilayer thickness is one of these ranges, said thicker zirconium nitride layer is made even more resistant against adhesive and abrasive wear.

The bilayer thickness is preferably in one of the following ranges: from 65 nm to 1050 nm, from 125 nm to 750 nm, from 250 nm to 560 nm.

According to a further embodiment of the cutting tool the zirconium nitride layers have the same individual thickness, which is the thickness of said thicker zirconium nitride layer, wherein the further nitride layers have the same individual thickness, which is the thickness of the further nitride layer which carries said thicker zirconium nitride layer. Thereby, homogenous wear properties of the multilayer coating are obtained. "the same thickness" is to be understood as a thickness which can have a variation which depends on the nature of the process used to form the layers of the multilayer coating even though the same thickness is intended. When the layers of the multilayer coating are formed by physical vapour deposition, "the same thickness" means, that the individual thicknesses of the layers can vary by +/- 10 %, e.g., when the individual thickness is 200 nm of one of the zirconium nitride layers, the individual thickness of one of the other zirconium nitride layers is in the range from 180 nm to 220 nm, which is considered to be "the same thickness" compared to said 200 nm thickness. Said +/- 10 % thickness variation applies to the further nitride layers under physical vapour deposition as well.

According to a further embodiment of the cutting tool the individual thickness of the zirconium nitride layers is larger than the individual thickness of the further nitride layers by a factor in the range from 1.2 to 15, preferably from 2.0 to 12.0, more preferably from 3.0 to 10.0, even further preferred from 3.0 to 5.5, most preferred from 3.5 to 4.6.

According to a further embodiment of the cutting tool said thicker zirconium nitride layer is a top layer of the multilayer coating exposed for metal chip contact. Thus, the cutting tool benefits from the improved wear properties of said thicker zirconium nitride layer during its first operation.

According to a further embodiment of the cutting tool the multilayer coating has a total thickness in the range from 500 nm to 15000 nm, preferably from 1000 nm to 10000 nm. When the total thickness of the multilayer coating is in said ranges, a good compromise between saving coating material on parts of the multilayer coating and a sufficient tool life is obtained.

According to a further embodiment of the cutting tool the total thickness of the multilayer coating and the total thickness of the base layer add up to a joint thickness in the range from 1000 nm to 25000 nm, preferably from 2000 nm to 15000 nm. When the joint thickness is in said ranges, a good compromise between saving material on parts of each of the base layer coating and the multilayer coating and a sufficient tool life is obtained.

According to a further embodiment of the cutting tool each of the zirconium nitride layers and each of the further nitride layers have been deposited by physical vapour deposition. Physical vapour deposition allows to better control the thicknesses of the zirconium nitride layers and further nitride layers. When the base layer is present it is preferably deposited by physical vapour deposition as well.

Further advantages of the cutting tool will be described in the following by reference to the figures and the embodiments shown therein.

The figures show
- Fig. 1:: a schematically depicted part of a cutting tool according to a first embodiment;
- Fig. 2:: a schematically depicted part of a cutting tool according to a second embodiment;
- Fig. 3:: a micrograph of a sample according to the second embodiment.

### EMBODIMENTS

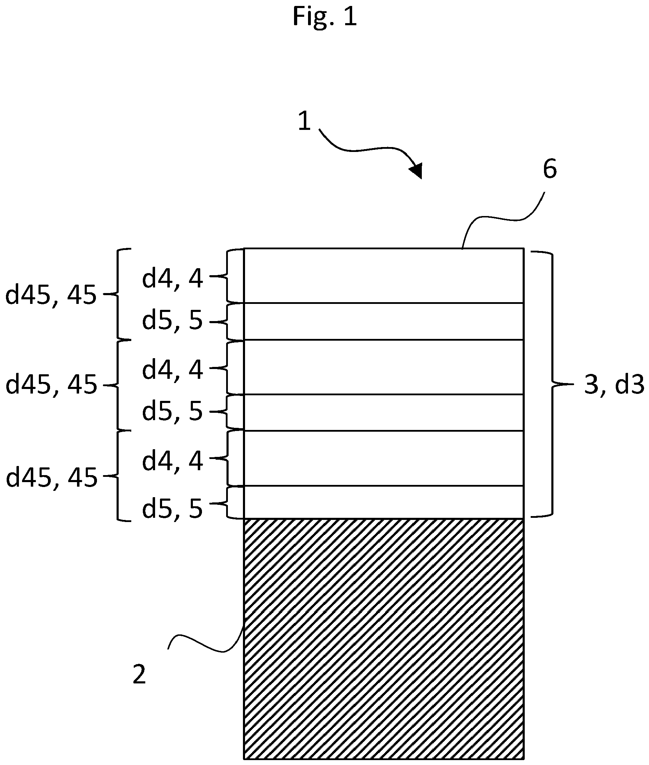

Fig. 1 shows a schematically depicted part of a cutting tool 1 according to a first embodiment. The cutting tool 1 has a tool body 2 and a multilayer coating 3. The multilayer coating 3 coats the tool body 2 thereby protecting the tool body 2 against wear. The multilayer coating 3 has zirconium nitride layers 4. The multilayer coating 3 has further nitride layers 5 alternatingly stacked with the zirconium nitride layers 4 such that each of the further nitride layers 5 carries one of the zirconium nitride layers 4.

The further nitride layers 5 each have an atomic composition of (Ti_{1-x-y}AlₓMe_{y})N_{α}, wherein x = 0.2 to 0.9, preferably x = 0.4 to 0.8, and y = 0 to 0.3, wherein Me is one or more metal atoms each selected from Ta, Si, Cr, W, V, Cr, Hf, Nb and Mo and α = 0.9 to 1.1. When y = 0 (Ti_{1-x-y}AlₓMe_{y})N_{α} reduces to (Ti₁₋ₓAlₓ)N_{α}. When α = 1.0 (Ti_{1-x-y}AlₓMe_{y})N_{α} reduces to (Ti_{1-x-y}AlₓMe_{y})N_{1.0}. When y = 0 and α = 1.0 (Ti_{1-x-y}AlₓMe_{y})N_{α} reduces to (Ti₁₋ₓAlₓ)N_{1.0}.

In the embodiment shown in Fig. 1, the further nitride layers 5 have the same atomic composition (Ti_{1-x-y}AlₓMe_{y})N_{α}, meaning that x, y and α are the same in each of the further nitride layers 5. The same atomic composition (same x, y and α) means that the values of x, y and α can vary from one further nitride layer 5 to the other further nitride layer 5 due to unavoidable fluctuations occurring during the formation of the further nitride layers 5, as in the in first embodiment fluctuations due to physical vapour deposition. In other words, x, y, and α will vary slightly even if they are intended to be the same, e.g., in case of physical vapour deposition, when the same alloy target is used for each further nitride layer 5.

The cutting tool 1 can also be used when the further nitride layers 5 have different atomic compositions each having (Ti_{1-x-y}AlₓMe_{y})N_{α}, wherein x, y and α are within the described ranges. Different atomic compositions means that the atomic compositions are deliberately intended to have a variation across the further nitride layers, e.g., by using different alloy targets under physical vapour deposition for the deposition of the further nitride layers 5.

As can be seen in Fig. 1, each zirconium nitride layer 4 is thicker than the further nitride layer 5 which carries said thicker zirconium nitride layer 4 which has been found to improve the tool life of the cutting tool 1. However, the cutting tool 1 can also be used when at least one of the zirconium nitride layers 4 is thicker than one of the further nitride layers 5 which carries said thicker zirconium nitride layer 4.

Each of the zirconium nitride layers 4 has an individual thickness d4 in the range from 35 nm to 750 nm, measured in a cross section as shown in Fig. 1 perpendicular to a top surface 6 the multilayer coating 3. d4 is preferably in one of the following ranges: 35 nm to 750 nm, from 200 nm to 600 nm, from 200 nm to 450 nm, 200 nm to 350 nm.

Each of the further nitride layers 5 has an individual thickness d5 in the range from 30 nm to 300 nm, preferably from 50 nm to 200 nm, measured analogously to the individual thicknesses d4. d5 is preferably in one of the following ranges: from 30 nm to 300 nm, from 50 nm to 150 nm, from 60 nm to 100 nm.

The sum of all of the individual thicknesses d4 and d5 adds up to a total thickness d3 of the multilayer coating 3. The total thickness d3 of the multilayer coating 3 is in the range from 500 nm to 15000 nm, preferably from 1000 nm to 10000 nm. d3 is preferably in one of the following ranges: from 500 nm to 15000 nm, from 1000 nm to 10000 nm, from 2000 nm to 4000 nm, from 2500 nm to 3700 nm.

As can been seen in Fig. 1, each individual thickness d4 is larger than each individual thickness d5.

The individual thicknesses d4 can vary amongst the zirconium nitride layers 4 or be the same. The latter is shown in in Fig. 1. The "same individual thickness" is to be understood as a thickness which has a variation which depends on the nature of the process used to form the zirconium nitride layers 4, even though the same thickness is intended. When the zirconium nitride layers 4 are formed by physical vapour deposition, "the same thickness" means, that the individual thicknesses of the zirconium nitride layers 4 can vary by +/- 10 % amongst each other.

The individual thicknesses d5 can vary amongst the further nitride layers 5 or be the same. The latter is shown in in Fig. 1. The "same individual thickness" is to be understood as a thickness which has a variation which depends on the nature of the process used to form the further nitride layers 5, even though the same thickness is intended. When the further nitride layers 5 are formed by physical vapour deposition, "the same thickness" means, that the individual thicknesses of the further nitride layers 5 can vary by +/- 10 % amongst each other.

The zirconium nitride layers 4 and the further nitride layers 5 are grouped as bilayers 45 in Fig. 1. Each bilayer 45 has thus one of the zirconium nitride layers 4 and one of the further nitride layers 5 which carries the zirconium nitride layer 4 of the bilayer 45. The individual thicknesses d4 and d5 of each bilayer 45 add up to bilayer thickness d45. d45 is preferably in one of the following ranges: from 65 nm to 1050 nm, from 125 nm to 750 nm, from 250 nm to 560 nm.

Each individual thickness d4 of each zirconium nitride layer 4 is related to the individual thickness d5 of the further nitride layer 5 which carries the thicker zirconium nitride layer 4, such that d4/d5 is larger than 1.0, preferably d4/d5 is in the range from 1.2 to 15.

d4/d5 is preferably in one of the following ranges: from 1.2 to 15.0, from 2.0 to 12.0, from 3.0 to 10.0, from 3.0 to 5.5, from 3.2 to 4.6.

One of the zirconium nitride layers 4 is a top layer of the multilayer coating 3 exposed to metal chip contact.

The tool body 2 is made from a cemented carbide. The tool body 2 has a cutting edge and optionally at least one chip flute, wherein the multilayer coating 3 is deposited on parts of the cutting edge and on the at least one chip flute, if present.

The zirconium nitride layers 4 and the further nitride layers 5 are each deposited by physical vapour deposition in the stacking order: further nitride layer 5 / zirconium nitride layer 4 / further nitride layer 5 / zirconium nitride layer 4 and so on, ending with a zirconium nitride layer 4. Physical vapour deposition is conducted in a nitrogen atmosphere using a zirconium target for the zirconium nitride layers 4 and an alloy target for the further nitride layers 5.

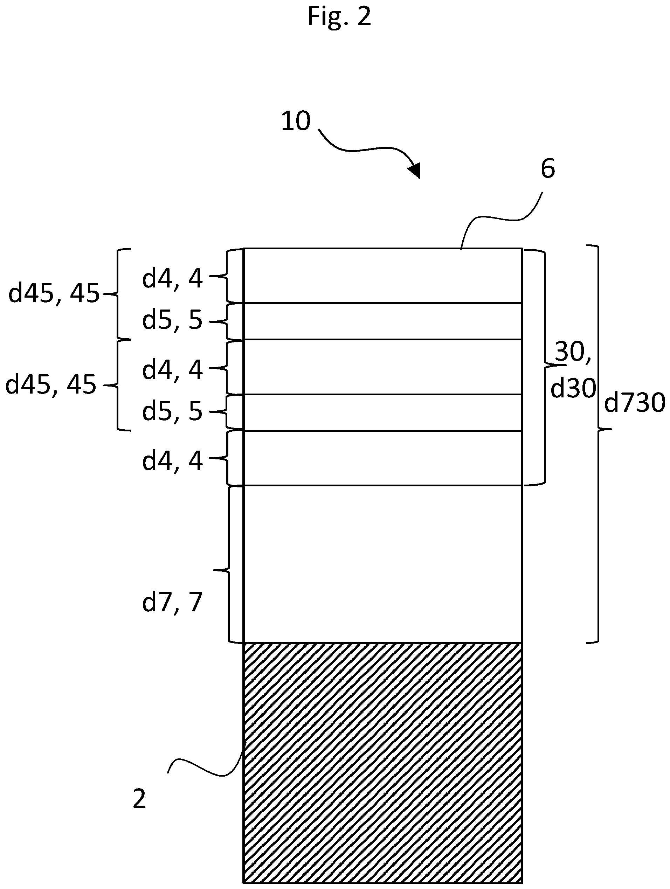

Fig. 2 shows a schematically depicted part of a cutting tool 10 according to a second embodiment. The cutting tool 10 has the tool body 2 of the cutting tool 1, a multilayer coating 30 protecting the tool body 2 against wear and a base layer 7, which carries the multilayer coating 30.

The only difference between the multilayer coatings 3 and 30 is that the further nitride layer 5 nearest to the tool body 2 of the multilayer coating 3 has been replaced by the base layer 7, such that the zirconium nitride layer 4 nearest to the tool body 2 is carried by the base layer 7, as depicted in Fig. 2.

Thus, it holds also for the multilayer coating 30 that each zirconium nitride layer 4 is thicker than the further nitride layer 5 which carries said thicker zirconium nitride layer 4. Likewise, the cutting tool 10 can also be used when at least one of the zirconium nitride layers 4 is thicker than one of the further nitride layers 5 which carries said thicker zirconium nitride layer 4. The individual thicknesses d4 and d5, and their thickness relation d4/d5 in the multilayer coating 30 are the same as those described for the multilayer coating 3.

The individual thicknesses d4 and d5 of the multilayer coating 30 add up to a total thickness d30 of the multilayer coating 30. The total thickness d30 is in the range described for the total thickness d3.

The base layer 7 has a total thickness d7, measured analogously to the thicknesses d4 and d5.

d7 is preferably in one of the following ranges: from 500 nm to 15000 nm, from 1000 nm to 10000 nm, from 2000 nm to 4000 nm, from 2500 nm to 3700 nm.

The thickness d7 of the base layer 7 is related to the total thickness d30 of the multilayer coating 30, such that d7/d30 is in the range from larger than 0 to 3.0.

d7/d30 is preferably in one of the following ranges: from larger than 0 to 3.0, from 0.5 to 2.0, from 0.5 to 1.7, from 0.75 to 1.7.

As can be seen in Fig. 2, the thickness d7 is larger than any individual thickness d5 of the further nitride layers 5.

The thicknesses d7 and d30 add up to a joint thickness d730 in the range from 1000 nm to 25000 nm, preferably from 2000 nm to 15000 nm.

The base layer 7 has an atomic composition of (Ti_{1-a-b}AlₐMe^{∗}_{b})N_{β}, wherein a = 0.20 to 0.90 and b = 0 to 0.30, preferably a = 0.40 to 0.80 and b = 0 to 0.30, wherein β = 0.9 to 1.1, wherein Me^{∗} is one or more metal atoms each selected from Ta, Si, Cr, W, V, Cr, Hf, Nb and Mo. When b = 0, the atomic composition of (Ti_{1-a-b}AlₐMe^{∗}_{b})N_{β} reduces to (Ti₁₋ₐAlₐ)N_{β}. When β = 1.0 (Ti_{1-a-b}AlₐMe^{∗}_{b})N_{β} reduces to (Ti_{1-a-b}AlₐMe^{∗}_{y})N_{1.0}. When b = 0 and β = 1.0, (Ti_{1-a-b}AlₐMe^{∗}_{b})N_{β} reduces to (Ti₁₋ₐAlₐ)N_{1.0}. In the embodiment shown in Fig. 2, the base layer 7 has its atomic composition (Ti_{1-a-b}AlₐMe^{∗}_{b})N_{β} set to match the atomic composition of the further nitride layers 5, having the same atomic composition in the above meaning of "same atomic composition" described for the further nitride layers 5, that x = a, y = b, α = β and Me = Me^{∗}, within the fluctuations occurring during physical vapour deposition, or in the case a different process for the formation of the baser layer 7 is used, fluctuations of that process. The same target can be used to deposit the base layer 7 and the further nitride layers 5 under physical vapour deposition, if x = a, y = b, α = β and Me = Me^{∗} is intended.

The cutting tool 10 can also be used if the base layer 7 has its atomic composition set to differ from the atomic composition of the further nitride layers 5, e.g., under physical vapor deposition, when targets of deliberately different compositions are used to deposit the base layer 7 and the further nitride layers 5.

The base layer 7 has been deposited by physical vapour deposition analogously to the further nitride layer 5 nearest to the tool body 2 in Fig. 1.

### EXPERIMENTAL RESULTS

Table 1 shows samples A to N (including sample E1) which each are coated cemented carbide end mill bodies having the same design and dimensions. Sample A has a base layer according to the second embodiment shown in Fig. 2 without a multilayer coating on top. Sample B has a multilayer coating according to the first embodiment shown in Fig. 1. Samples C to N (including sample E1) each have a base layer and a multilayer coating according to the second embodiment shown in in Fig. 2.

The specific atomic compositions and coating structures of samples A to N (including sample E1) are given in the column "Coating (BL = base layer, ML = multilayer)" of table 1. ML means that the corresponding coating has a multilayer coating having zirconium nitride layers and further nitride layers alternatingly stacking with the zirconium nitrides as shown for the multilayer coatings 3 and 30 in Fig. 1 and 2, respectively. The atomic composition of the further nitride layers is given in table 1, column "Coating (BL = base layer, ML = multilayer)". BL means that the coating of the samples has a base layer, if present, which carries a multilayer coating, if present, as shown for the base layer 7 in Fig. 2. The composition of the base layer is expressed analogously to the composition of the further nitride layers.

The total thickness of each base layer, if present, is given in column "d(BL)" of table 1, which corresponds to the base layer thickness d7 in Figure 2. The total thickness of each multilayer coating, if present, is given in column "d(ML)" of table 1. Each ratio of the total base layer thickness to the total multilayer coating thickness is given in column "d(BL)/d(ML)" of table 1, if a multilayer coating is present; said ratio corresponds to the ratio of d7/d30 disclosed in Fig. 2. The total thickness of the coatings is given in column "d(total)" of table 1, being the sum of the total multilayer coating thickness, if present, and the total bas thickness, if present. The individual thicknesses of the zirconium nitride layers, if present, are given in column "d(zirconium nitride)" of table 1. The individual thicknesses of the further nitride layers, if present, are given in column "d((Ti_{1-x-y}AlₓMe_{y})N_{α})" of table 1. The bilayer thicknesses as expressed by d45 in Figs. 1 and 2 are given in column

"d(zirconium nitride) + d((Ti_{1-x-y}AlₓMe_{y})N_{α}" of table 1, if present. Each ratio of the individual thickness of the zirconium nitride layers to the individual thickness of the further nitride layers is given in column "d(zirconium nitride)/d((Ti_{1-x-y}AlₓMe_{y})N_{α}" of table 1, if present.

The milling distance each sample was used is given in column "milling distance" of table 1.

The coatings given in table 1, column "Coating (BL = base layer, ML = multilayer)", were each deposited by physical vapour deposition in a nitrogen atmosphere in the following way.

For sample A an alloy target of composition 33.0 atomic percent titanium and 67.0 atomic percent aluminium (abbreviated in the following as TiAl 33/67 target) was used to deposit a base layer onto the tool body of sample A until the base layer reached its thickness given in table 1.

For sample B a TiAl 33/67 target was used to deposit a first further nitride layer onto the tool body of sample B, until the first further nitride layer reached its individual thickness given in table 1, column "d((Ti_{1-x-y}AlₓMe_{y})N_{α}", then a zirconium target was used to deposited a first layer of zirconium nitride onto the first further nitride layer, until the first zirconium nitride layer reached its individual thickness given table 1, column "d(zirconium nitride)", then a second further nitride layer was deposited onto the first zirconium nitride layer analogously to the first further nitride layer. The last two deposition steps were repeated such that the multilayer coating of sample A with its total multilayer coating thickness given in table 1, column "d(ML)", was reached, where a zirconium nitride layer is a top layer. The thicknesses of the zirconium nitride layers were intended to be the same in the multilayer coating of sample B, subject to a thickness fluctuation of +/- 10 % amongst the zirconium nitride layers. The thicknesses of the further nitride layers were intended to be same in the multilayer coating of sample B, subject to a thickness fluctuation of +/- 10 % amongst the further nitride layers.

For each of the samples C to G (including sample E1) a base layer of its composition given in table 1was deposited analogously to the base layer of Sample A, followed by a multilayer coating deposition analogously to sample B onto each base layer.

For sample H a base layer was deposited using an alloy target of composition 49.5 atomic percent titanium, 49.5 atomic percent aluminium and 1.0 atomic percent tantalum (abbreviated in the following as TiAITa 49.5/49.5/1 target) onto the tool body of sample H analogously to sample A, then a multilayer coating was deposited onto the base layer of sample H analogously to sample B with the difference, that the TiAITa 49.5/49.5/1 target was used instead of the TiAl 33/67 target.

For sample I a base layer was deposited using an alloy target of composition 42.5 atomic percent titanium, 42.5 atomic percent aluminium and 15.0 atomic percent tantalum (abbreviated in the following as TiAITa 42.5/42.5/15 target) onto the tool body of sample I analogously to sample A, then a multilayer coating was deposited onto the base layer of sample I analogously to sample B with the difference, that the TiAITa 42.5/42.5/15 target was used instead of the TiAl 33/67 target.

For sample J a base layer was deposited using an alloy target of composition 28.5 atomic percent titanium, 66.5 atomic percent aluminium and 5.0 atomic percent chromium was used (abbreviated in the following as TiAICr 28.5/66.5/5 target) onto the tool body of sample J analogously to sample A, then a multilayer coating was deposited onto the base layer of sample J analogously to sample B with the difference, that the TiAICr 28.5/66.5/5 target was used instead of the TiAl 33/67 target.

For sample K a base layer was deposited using an alloy target of composition 34.4 atomic percent titanium, 63.5 atomic percent aluminium and 2.1 atomic percent vanadium was used (abbreviated in the following as TiAIV 34.4/63.5/2.1 target) onto the tool body of sample K analogously to sample A, then a multilayer coating was deposited onto the base layer of sample K analogously to sample B with the difference, that the TiAIV 34.4/63.5/2.1 target was used instead of the TiAl 33/67 target.

For sample L a base layer was deposited using an alloy target of composition 29.8 atomic percent titanium, 66.0 atomic percent aluminium and 4.2 atomic percent silicon (abbreviated in the following as TiAISi 29.8/66/4.2 target) onto the tool body of sample L analogously to sample A, then a multilayer coating was deposited onto the base layer of sample L analogously to sample B with the difference, that the TiAISi 29.8/66/4.2 target was used instead of the TiAl 33/67 target.

For sample M a base layer was deposited using an alloy target of composition 31.0 atomic percent titanium, 65.5 atomic percent aluminium and 3.5 atomic percent tungsten was used (abbreviated in the following as TiAIW 31/65.5/3.5 target) onto the tool body of sample M analogously to sample A, then a multilayer coating was deposited onto the base layer of sample M analogously to sample B with the difference, that the TiAIW 31/65.5/3.5 target was used instead of the TiAl 33/67 target.

For sample N a base layer was deposited using an alloy target of composition 32.0 atomic percent titanium, 65.5 atomic percent aluminium and 2.5 atomic percent molybdenum (abbreviated in the following as TiAIMo 32/65.5/2.5 target) onto the tool body of sample N analogously to sample A, then a multilayer coating was deposited onto the base layer of sample N analogously to sample B with the difference, that the TiAIMo 32/65.5/2.5 target was used instead of the TiAl 33/67 target.

The compositions given for each coating in table 1, column "Coating (BL = base layer, ML = multilayer)" are the ones measured on each sample A to N (including sample E1) using energy-dispersive X-ray spectroscopy in a scanning electron microscope dedicated for light chemical element detection, e.g., nitrogen (N).

The thicknesses given for each coating in table 1, columns "d(BL)", "d(ML)", "d(total)", "d(zirconium nitride)" and "d((Ti_{1-x-y}AlₓMe_{y})N_{α})", are the ones measured in cross-sections analogously to Figs. 1 and 2 using a scanning electron microscope, wherein the measured d(zirconium nitride) and d((Ti_{1-x-y}AlₓMe_{y})N_{α}) values are each average thicknesses over all of the corresponding zirconium nitride layers and further nitride layers in the corresponding multilayer coating, respectively.

The milling distances given in the corresponding column of table 1 were obtained in the following way. Samples A to N (including sample E1) were used to mill into a titanium base alloy of composition 90 weight percent titanium, 6 weight percent aluminium and 4 weight percent vanadium under the same milling conditions. The milling conditions were: milling speed 80 m/minute, feed per revolution 0.05 mm, milling depth 4 mm and milling width 10 mm. The tool life criterium was that milling was stopped when considerable wear indicated chipping of cutting edges. The milling distance was recorded when the tool life criterium was reached.

Comparison of the milling distances given in table 1 shows that the multilayer coating of samples B to N (including sample E1) leads to a longer tool life in comparison to when only a base layer is used for wear protection, as for sample A.

Comparison of samples B, C and D shows the influence of different d(BL)/d(ML) ratios when d(zirconium nitride)/d((Ti_{1-x-y}AlₓMe_{y})N_{α}) is kept (nearly) constant (3.4 to 3.5) in the range from 3.0 to 10.0: the milling distance gets larger when d(BL)/d(ML) is in its preferred range of from 0.5 to 1.7 (sample C has d(BL)/d(ML) = 0.7 and a milling distance of 54 m), and gets smaller when d(BL)/d(ML) is outside of its preferred range from 0.5 to 1.7 (sample B has d(BL)/d(ML) = 0 (no base layer) and a milling distance of 42 m, sample D has d(BL)/d(ML) = 2.0 and a milling distance of 40 m).

Comparison of samples E, E1 and F shows the influence of different d(zirconium nitride)/d((Ti_{1-x-y}AlₓMe_{y})N_{α}) ratios when d(BL)/d(ML) is kept (nearly) constant (1.3 to 1.4) in its preferred range from 0.5 to 1.7: the milling distance gets larger when d(zirconium nitride)/d((Ti_{1-x-y}AlₓMe_{y})N_{α}) is in its preferred range from 3.0 to 10.0, and gets smaller when d(zirconium nitride)/d((Ti_{1-x-y}AlₓMe_{y})N_{α}) is outside of its preferred range from 3.0 to 10.0 (sample E1 has d(zirconium nitride)/d((Ti_{1-x-y}AlₓMe_{y})N_{α}) = 5.2 and a milling distance of 51 m), sample E has d(zirconium nitride)/d((Ti_{1-x-y}AlₓMe_{y})N_{α}) = 1.1 and a milling distance of 41 m, sample F has d(zirconium nitride)/d((Ti_{1-x-y}AlₓMe_{y})N_{α}) = 11.2 and a milling distance of 40 m).

Comparison of samples F and G shows the influence of different d(zirconium nitride) thicknesses when d(BL)/d(ML) is kept constant (1.4) in its preferred range from 0.5 to 1.7 and when the d(zirconium nitride)/d((Ti_{1-x-y}AlₓMe_{y})N_{α}) ratio is kept nearly constant (11.0 to 11.2) in its preferred range from 2.0 to 12.0: the milling distance gets larger when d(zirconium nitride) decreases within the range from 35 nm to 750 nm (sample F has d(zirconium nitride) = 730 nm and a milling distance of 40 m, sample G has smaller d(zirconium nitride) = 561 nm and a larger milling distance of 49 m).
Samples H and I each have Me = Ta (Me^{∗} = Ta) and y in the range from larger 0 to 0.30.
Sample J has Me = Cr (Me^{∗} = Cr) and y in the range from larger 0 to 0.30.
Sample K has Me = V (Me^{∗} = V) and y in the range from larger 0 to 0.30
Sample L has Me = Si (Me^{∗} = Si) and y in the range from larger 0 to 0.30.
Sample M has Me = W (Me^{∗} = W) and y in the range from larger 0 to 0.30.
Sample N has Me = Mo (Me^{∗} = Mo) and y is in the range from larger 0 to 0.30.

The following further samples C1 to C6 were made, each having a base layer and a multilayer coating carried by the base layer, wherein each multilayer coating of the further samples has zirconium nitride layers and further nitride layers, stacked analogously to the second embodiment in Fig. 2, and wherein the thicknesses of the base layer, the further nitride layers and the zirconium nitride layers were close (+/- 10 % thickness difference relative to the corresponding layer thickness of sample C) to the ones of sample C in table 1:
Sample C1, BL ((Ti_{0.21}Al_{0.79})N_{1.0}) + ML (zirconium nitride/(Ti_{0.21}Al_{0.79})N_{1.0}),
Sample C2, BL ((Ti_{0.30}Al_{0.70})N_{1.0}) + ML (zirconium nitride/(Ti_{0.30}Al_{0.70})N_{1.0}),
Sample C3, BL ((Ti_{0.31}Al_{0.69})N_{1.0}) + ML (zirconium nitride/(Ti_{0.31}Al_{0.69})N_{1.0}),
Sample C4, BL ((Ti_{0.39}Al_{0.61})N_{1.0}) + ML (zirconium nitride/(Ti_{0.39}Al_{0.61})N_{1.0}),
Sample C5, BL ((Ti_{0.51}Al_{0.49})N_{1.0}) + ML (zirconium nitride/(Ti_{0.51}Al_{0.49})N_{1.0}),
Sample C6, BL ((Ti_{0.60}Al_{0.40})N_{1.0}) + ML (zirconium nitride/(Ti_{0.60}Al_{0.40})N_{1.0}).

Each of the samples C1 to C6, having x =0.4 to 0.8 and y = 0, had a milling distance close to the milling distance of sample C given in table 1.

Further samples close to the coating composition and coating architecture of sample C were made, wherein α (α = β) = 1.1 and α (α = β) = 0.9, having a milling distance close to the milling distance of sample C given in table 1.

The following further samples H1 and H2 were made, each having a base layer and a multilayer coating carried by the base layer, wherein each multilayer coating of the further samples has zirconium nitride layers and further nitride layers, stacked analogously to the second embodiment in Fig. 2, and wherein the thicknesses of the base layer, the further nitride layers and the zirconium nitride layers were close (+/- 10 % thickness difference relative to the corresponding layer thickness of sample H) to the ones of sample H in table 1:
Sample H1, BL ((Ti_{0.34}Al_{0.61}Ta_{0.05})N_{1.0}) + ML (zirconium nitride/(Ti_{0.34}Al_{0.61}Ta_{0.05})N_{1.0},
Sample H2, BL ((Ti_{0.30}Al_{0.59}Ta_{0.11})N_{1.0}) + ML (zirconium nitride/(Ti_{0.30}Al_{0.59}Ta_{0.11})N_{1.0}.

Each of the samples H1 and H2, having x =0.4 to 0.8 and y larger than 0 and y smaller than 0.3, had a milling distance close to the milling distance of sample H given in table 1.

Further samples J1 and J2 were made, each having a base layer and a multilayer coating carried by the base layer, wherein each multilayer coating of the further samples has zirconium nitride layers and further nitride layers, stacked analogously to the second embodiment in Fig. 2, and wherein the thicknesses of the base layer, the further nitride layers and the zirconium nitride layers were close (+/-10 % thickness difference relative to the corresponding layer thickness of sample J) to the ones of sample J in table 1:
Sample J1, BL ((Ti_{0.13}Al_{0.60}Cr_{0.27})N_{1.0}) + ML (zirconium nitride/(Ti_{0.13}Al_{0.60}Cr_{0.27})N_{1.0}),
Sample J2, BL ((Ti_{0.26}Al_{0.61}Cr_{0.13})N_{1.0}) + ML (zirconium nitride/(Ti_{0.26}Al_{0.61}Cr_{0.13})N_{1.0}).

Each of the samples J1 and J2, having x =0.4 to 0.8 and y larger than 0 and y smaller than 0.3, had a milling distance close to the milling distance of sample J given in table 1.

Further samples K1 and K2 were made, each having a base layer and a multilayer coating carried by the base layer, wherein each multilayer coating of the further samples has zirconium nitride layers and further nitride layers, stacked analogously to the second embodiment in Fig. 2, and wherein the thicknesses of the base layer, the further nitride layers and the zirconium nitride layers were close (+/-10 % thickness difference relative to the corresponding layer thickness of sample K) to the ones of sample K in table 1:
Sample K1, BL ((Ti_{0.19}Al_{0.59}V_{0.22})N_{1.0}) + ML (zirconium nitride/(Ti_{0.19}Al_{0.59}V_{0.22})N_{1.0}),
Sample K2, BL ((Ti_{0.26}Al_{0.59}V_{0.15})N_{1.0}) + ML (zirconium nitride/(Ti_{0.26}Al_{0.59}V_{0.15})N_{1.0}).

Each of the samples K1 and K2, having x =0.4 to 0.8 and y larger than 0 and y smaller than 0.3, had a milling distance close to the milling distance of sample K given in table 1.

Further samples L1 and L2 were made, each having a base layer and a multilayer coating carried by the base layer, wherein each multilayer coating of the further samples has zirconium nitride layers and further nitride layers, stacked analogously to the second embodiment in Fig. 2, and wherein the thicknesses of the base layer, the further nitride layers and the zirconium nitride layers were close (+/-10 % thickness difference relative to the corresponding layer thickness of sample L) to the ones of sample L in table 1:
Sample L1, BL ((Ti_{0.18}Al_{0.59}Si_{0.23})N_{1.0}) + ML (zirconium nitride/(Ti_{0.18}Al_{0.59}Si_{0.23})N_{1.0}),
Sample L2, BL ((Ti_{0.27}Al_{0.61}Si_{0.12})N_{1.0}) + ML (zirconium nitride/(Ti_{0.27}Al_{0.61}Si_{0.12})N_{1.0}).

Each of the samples L1 and L2, having x =0.4 to 0.8 and y larger than 0 and y smaller than 0.3, had a milling distance close to the milling distance of sample L given in table 1.

Further samples M1 and M2 were made, each having a base layer and a multilayer coating carried by the base layer, wherein each multilayer coating of the further samples has zirconium nitride layers and further nitride layers, stacked analogously to the second embodiment in Fig. 2, and wherein the thicknesses of the base layer, the further nitride layers and the zirconium nitride layers were close (+/-10 % thickness difference relative to the corresponding layer thickness of sample M) to the ones of sample M in table 1:
Sample M1, BL ((Ti_{0.12}Al_{0.60}W_{0.28})N_{1.0}) + ML (zirconium nitride/(Ti_{0.12}Al_{0.60}W_{0.28})N_{1.0}),
Sample M2, BL ((Ti_{0.24}Al_{0.59}W_{0.17})N_{1.0}) + ML (zirconium nitride/(Ti_{0.24}Al_{0.59}W_{0.17})N_{1.0}).

Each of the samples M1 and M2, having x =0.4 to 0.8 and y larger than 0 and y smaller than 0.3, had a milling distance close to the milling distance of sample M given in table 1.

Further samples N1 and N2 were made, each having a base layer and a multilayer coating carried by the base layer, wherein each multilayer coating of the further samples has zirconium nitride layers and further nitride layers, stacked analogously to the second embodiment in Fig. 2, and wherein the thicknesses of the base layer, the further nitride layers and the zirconium nitride layers were close (+/-10 % thickness difference relative to the corresponding layer thickness of sample N) to the ones of sample N in table 1:
Sample N1, BL ((Ti_{0.32}Al_{0.59}Mo_{0.09})N_{1.0}) + ML (zirconium nitride/(Ti_{0.32}Al_{0.59}Mo_{0.09})N_{1.0}),
Sample N2, BL ((Ti_{0.18}Al_{0.61}Mo_{0.21})N_{1.0}) + ML (zirconium nitride/(Ti_{0.18}Al_{0.61}Mo_{0.21})N_{1.0}).

Each of the samples N1 and N2, having x =0.4 to 0.8 and y larger than 0 and y smaller than 0.3, had a milling distance close to the milling distance of sample N given in table 1.

Further samples O1 to O3 were made, each having a base layer and a multilayer coating carried by the base layer, wherein each multilayer coating of the further samples has zirconium nitride layers and further nitride layers, stacked analogously to the second embodiment in Fig. 2, and wherein the thicknesses of the base layer, the further nitride layers and the zirconium nitride layers were close (+/-10 % thickness difference relative to the corresponding layer thickness of sample N) to the ones of sample N in table 1:
Sample 01, BL ((Ti_{0.35}Al_{0.60}Nb_{0.05})N_{1.0}) + ML (zirconium nitride/(Ti_{0.35}Al_{0.60}Nb_{0.05})N_{1.0}),
Sample O2, BL ((Ti_{0.30}Al_{0.59}Nb_{0.11})N_{1.0}) + ML (zirconium nitride/(Ti_{0.30}Al_{0.59}Nb_{0.11})N_{1.0}),
Sample O3, BL ((Ti_{0.21}Al_{0.59}Nb_{0.20})N_{1.0}) + ML (zirconium nitride/(Ti_{0.21}Al_{0.59}Nb_{0.20})N_{1.0}).

Each of the samples O1 to O3, having x =0.4 to 0.8 and y larger than 0 and y smaller than 0.3, had a milling distance close to the milling distance of sample N given in table 1.

Further samples P1 to P3 were made, each having a base layer and a multilayer coating carried by the base layer, wherein each multilayer coating of the further samples has zirconium nitride layers and further nitride layers, stacked analogously to the second embodiment in Fig. 2, and wherein the thicknesses of the base layer, the further nitride layers and the zirconium nitride layers were close (+/- 10 % thickness difference relative to the corresponding layer thickness of sample N) to the ones of sample N in table 1:
Sample P1, BL ((Ti_{0.32}Al_{0.61}Hf_{0.07})N_{1.0}) + ML (zirconium nitride/(Ti_{0.32}Al_{0.61}Hf_{0.07})N_{1.0}),
Sample P2, BL ((Ti_{0.24}Al_{0.61}Hf_{0.15})N_{1.0}) + ML (zirconium nitride/(Ti_{0.24}Al_{0.61}Hf_{0.15})N_{1.0}),
Sample P3, BL ((Ti_{0.15}Al_{0.59}Hf_{0.26})N_{1.0}) + ML (zirconium nitride/(Ti_{0.15}Al_{0.59}Hf_{0.26})N_{1.0}).

Each of the samples P1 to P3, having x =0.4 to 0.8 and y larger than 0 and y smaller than 0.3, had a milling distance close to the milling distance of sample N given in table 1.

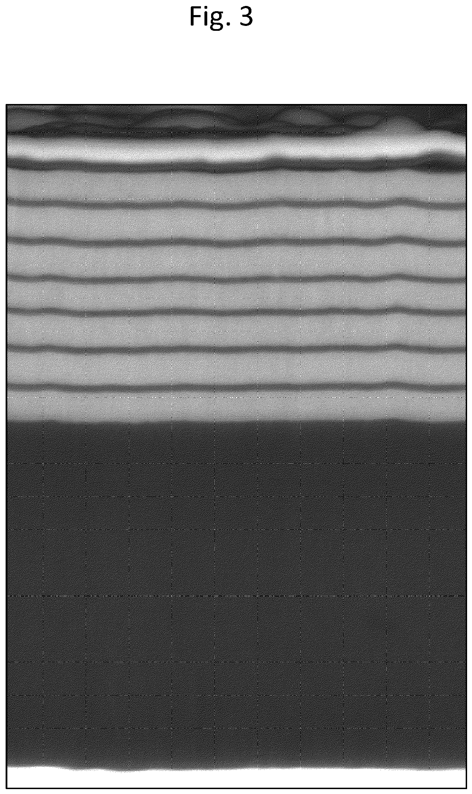

Fig. 3 shows a scanning electron micrograph obtained from back-scattered electrons of sample E1 in a cross-section according to Fig. 2.

From bottom to top Fig. 3 shows a part of the tool body (bright/white thin bottom slab) of sample E1, the base layer of sample E1 (larger dark grey slab) and the multilayer coating of sample E1 (thinner dark grey slabs are the further nitride layers, thicker light grey slabs are the zirconium nitride layers).

The micrograph of Fig. 3 shows seven zirconium layers and six further nitride layers; the outermost two layers (black and bright "top layers") are due to sample preparation are not part of the coating of sample E1.

The micrograph of Fig. 3 shows that the zirconium nitride layer nearest to the tool body is carried by the base layer, the zirconium nitride layers farther away from the tool body are each being carried by one of the further nitride layers, each zirconium nitride layer being thicker than the further nitride layer carrying it.

**Table 1: Experimental results**

| Sample | Coating (BL = base layer, ML = multilayer) | d(BL) (nm) | d(ML) (nm) | d(total) (nm) | d(BL)/d(ML) | d(zirconium nitride) (nm) | d((Ti_{1-x-y}AlₓMe_{y})N_{α}) (nm) | d(zirconium nitride) + d((Ti_{1-x-y}AlₓMe_{y})N_{α}) (nm) | d(zirconium nitride)/ d((Ti_{1-x-y}AlₓMe_{y})N_{α}) | Milling distance (m) |
|---|---|---|---|---|---|---|---|---|---|---|
| A | BL ((Ti_{0.41}Al_{0.59})N_{1.0}) | 5100 | - | 5100 | - | - | - | - | - | 32 |
| B | ML (zirconium nitride/(Ti_{0.40}Al_{0.60})N_{1.0}) | 0 | 5066 | 5066 | 0 | 230 | 68 | 298 | 3.4 | 42 |
| c | BL ((Ti_{0.41}Al_{0.59})N_{1.0}) + ML (zirconium nitride/(Ti_{0.41}Al_{0.59})N_{1.0}) | 2040 | 3135 | 5175 | 0.7 | 222 | 63 | 285 | 3.5 | 54 |
| D | BL ((Ti_{0.39}Al_{0.61})N_{1.0}) + ML (zirconium nitride/(Ti_{0.39}Al_{0.61})N_{1.0}) | 3638 | 1842 | 5480 | 2.0 | 239 | 68 | 307 | 3.5 | 40 |
| E | BL ((Ti_{0.40}Al_{0.60})N_{1.0}) + ML (zirconium nitride/(Ti_{0.40}Al_{0.60})N_{1.0}) | 2890 | 2174 | 5064 | 1.3 | 76 | 69 | 145 | 1.1 | 41 |
| E1 | BL ((Ti_{0.41}Al_{0.59})N_{1.0}) + ML (zirconium nitride/(Ti_{0.40}Al_{0.59})N_{1.0}) | 2907 | 2154 | 5061 | 1.3 | 301 | 58 | 359 | 5.2 | 51 |
| F | BL ((Ti_{0.39}Al_{0.61})N_{1.0}) + ML (zirconium nitride/(Ti_{0.39}Al_{0.61})N_{1.0}) | 3400 | 2384 | 5784 | 1.4 | 730 | 65 | 795 | 11.2 | 40 |
| G | BL ((Ti_{0.40}Al_{0.60})N_{1.0}) + ML (zirconium nitride/(Ti_{0.40}Al_{0.60})N_{1.0}) | 3350 | 2448 | 5798 | 1.4 | 561 | 51 | 612 | 11.0 | 49 |
| H | BL ((Ti_{0.32}Al_{0.67}Ta_{0.01})N_{1.0}) + ML (zirconium nitride/(Ti_{0.32}Al_{0.67}Ta_{0.01})N_{1.0}) | 2856 | 2100 | 4956 | 1.4 | 246 | 54 | 300 | 4.6 | 53 |
| I | BL ((Ti_{0.43}Al_{0.34}Ta_{0.23})N_{1.0}) + ML (zirconium nitride/(Ti_{0.43}Al_{0.34}Ta_{0.23})N_{1.0}) | 3383 | 2317 | 5700 | 1.5 | 243 | 88 | 331 | 2.8 | 50 |
| J | BL ((Ti_{0.32}Al_{0.60}Cr_{0.08})N_{1.0}) + ML (zirconium nitride/(Ti_{0.32}Al_{0.60}Cr_{0.08})N_{1.0}) | 2900 | 2870 | 5770 | 1.0 | 330 | 80 | 410 | 4.1 | 51 |
| K | BL ((Ti_{0.34}Al_{0.64}V_{0.02})N_{1.0}) + ML (zirconium nitride/(Ti_{0.34}Al_{0.64}V_{0.02})N_{1.0}) | 2840 | 2298 | 5138 | 1.2 | 291 | 92 | 383 | 3.2 | 52 |
| L | BL ((Ti_{0.34}Al_{0.63}Si_{0.03})N_{1.0}) + ML (zirconium nitride/(Ti_{0.34}Al_{0.63}Si_{0.03})N_{1.0}) | 2920 | 2496 | 5416 | 1.2 | 340 | 76 | 416 | 4.5 | 49 |
| M | BL ((Ti_{0.35}Al_{0.60}W_{0.05})N_{1.0}) + ML (zirconium nitride/(Ti_{0.35}Al_{0.60}W_{0.05})N_{1.0} | 2520 | 2645 | 5165 | 1.0 | 402 | 127 | 529 | 3.2 | 47 |
| N | BL ((Ti_{0.36}Al_{0.61}Mo_{0.03})N_{1.0}) + ML (zirconium nitride/(Ti_{0.36}Al_{0.61}Mo_{0.03})N_{1.0} | 2570 | 2884 | 5454 | 0.9 | 325 | 87 | 412 | 3.7 | 51 |

## Claims

1. Cutting tool (1, 10), the cutting tool (1, 10) has a tool body (2) and a multilayer coating (3, 30), wherein the multilayer coating (3, 30) protects the tool body (2) against wear during cutting, wherein the multilayer coating (3, 30) has zirconium nitride layers (4), wherein the multilayer coating (3, 30) has further nitride layers (5) alternatingly stacked with the zirconium nitride layers (4), such that each of the further nitride layers (5) carries one of the zirconium nitride layers (4), wherein the further nitride layers (5) each have an atomic composition of (Ti_{1-x-y}AlₓMe_{y})N_{α}, wherein x = 0.2 to 0.9 and y = 0 to 0.3, wherein Me is one or more metal atoms each selected from Ta, Si, Cr, W, V, Cr, Hf, Nb and Mo, wherein α = 0.9 to 1.1, wherein each of the zirconium nitride layers (4) has a thickness (d4) in the range from 35 nm to 750 nm, wherein each of the further nitride layers (5) has a thickness (d5) in the range from 30 nm to 300 nm, wherein at least one of the zirconium nitride layers (4) is thicker than one of the further nitride layers (5) which carries said thicker zirconium nitride layer (4).

2. Cutting tool (1, 10) according to claim 1, wherein said thicker zirconium nitride layer (4) is thicker than the further nitride layer (5) which carries said thicker zirconium nitride layer (5) by a factor in the range from 1.2 to 15.0.

3. Cutting tool (1, 10) according to any of the preceding claims, wherein the cutting tool (1, 10) has a base layer (7), wherein the base layer (7) has an atomic composition of (Ti_{1-a-b}AlₐMe^{∗}_{b})N_{β}, wherein a = 0.20 to 0.90 and b = 0 to 0.30, wherein Me^{∗} is one or more metal atoms each selected from Ta, Si, Cr, W, V, Cr, Hf, Nb and Mo, wherein the base layer (7) carries the multilayer coating (3, 30) on parts of the tool body (2), wherein the base layer (7) is thicker than any one of the further nitride layers (5).

4. Cutting tool (1, 10) according to claim 3, wherein the base layer (7) carries one of the zirconium nitride layers (4).

5. Cutting tool (1, 10) according to claim 3 or 4, wherein the base layer (7) has a total thickness (d7) in the range from 500 nm to 15000 nm.

6. Cutting tool (1, 10) according to any of one of claims 3 to 5, wherein the base layer (7) has a total thickness (d7), wherein the multilayer coating (3, 30) has a total thickness (d3, d30), wherein a ratio of the total thickness (d7) of the base layer (7) to the total thickness (d3, d30) of the multilayer coating (3, 30) is in the range from larger than 0 to 3.0.

7. Cutting tool (1, 10) according to any of the preceding claims, wherein the tool body (2) is made from a cemented carbide.

8. Cutting tool (1, 10) according to claim 7, wherein the cemented carbide has a metallic alloy which amounts from 5 weight percent to 20 weight percent in the cemented carbide, wherein the metallic alloy is a cobalt base alloy, wherein the cemented carbide has carbide particles which are tungsten carbide particles.

9. Cutting tool (1, 10) according to any of the preceding claims, wherein the thickness (d4) of said thicker zirconium nitride layer (4) and the thickness (d5) of the further nitride layer (5) which carries said thicker zirconium nitride layer (4) add up to a bilayer thickness (d45) in the range from 65 nm to 1050 nm.

10. Cutting tool (1, 10) according to any of the preceding claims, wherein the zirconium nitride layers (4) have the same individual thickness (d4), which is the thickness (d4) of said thicker zirconium nitride layer (4), wherein the further nitride layers (5) have the same individual thickness (d5), which is the thickness (d4) of the further nitride layer (4) which carries said thicker zirconium nitride layer (5).

11. Cutting tool (1, 10) according to claim 10, wherein the individual thickness (d4) of the zirconium nitride layers (4) is larger than the individual thickness (d5) of the further nitride layers (5) by a factor in the range from 1.2 to 15.

12. Cutting tool (1, 10) according to any of the preceding claims, wherein said thicker zirconium nitride layer (4) is a top layer (4) of the multilayer coating (3, 30) exposed for metal chip contact.

13. Cutting tool (1, 10) according to any of the preceding claims, wherein the multilayer coating (3, 30) has a total thickness (d3, d30) in the range from 500 nm to 15000 nm.

14. Cutting tool (1, 10) according to claim 13 and claim 5, wherein the total thickness (d3, d30) of the multilayer coating (3, 30) and the total thickness (d7) of the base layer (7) add up to a joint thickness (d730) in the range from 1000 nm to 25000 nm.

15. Cutting tool (1, 10) according to any of the preceding claims, wherein each of the zirconium nitride layers (4) and each of the further nitride layers (5) have been deposited by physical vapour deposition.
